# FASCICULE DE BREVET EUROPEEN

(11) **EP 3 177 122 B1**
(45) Date de publication et mention de la délivrance du brevet: **09.09.2020**
(21) Numéro de dépôt: 16201060.7
(22) Date de dépôt: 29.11.2016
(51) Int. Cl.: H05K 5/06, H05K 7/14

(54) **SUPPORT D'UNE UNITE ELECTRONIQUE, DISPOSITIF ELECTRIQUE LE COMPRENANT ET MACHINE ELECTRIQUE COMPRENANT LEDIT DISPOSITIF ELECTRIQUE**
HALTERUNG EINER ELEKTRONISCHEN EINHEIT, DIESE UMFASSENDE ELEKTRISCHE VORRICHTUNG UND ELEKTRISCHE MASCHINE, DIE DIESE ELEKTRISCHE VORRICHTUNG UMFASST
MOUNTING FOR AN ELECTRONIC UNIT, ELECTRICAL DEVICE COMPRISING SAME, AND ELECTRIC MACHINE COMPRISING SAID ELECTRICAL DEVICE

(30) Priorité: 02.12.2015 FR 1561736
(43) Date de publication de la demande: 07.06.2017
(73) Titulaire: Valeo Systemes de Controle Moteur, 95800 Cergy Saint Christophe (FR)
(72) Inventeur: TRAMET, Guillaume, 78360 Montesson (FR); MAS, Arnaud, 95000 Cergy (FR); SACCO, Ernesto, 95000 Cergy (FR)
(74) Mandataire: Novembre, Christophe Adelphe

(56) Documents cités:
- FR-A1- 2 932 022
- FR-A1- 3 014 257
- FR-A1- 3 020 727

## Description

L'invention a pour objet un support d'une unité électronique, notamment une carte électronique, un dispositif électrique comprenant ledit support, et une machine électrique comprenant ledit dispositif électrique.

Le document FR 3 020 727 A1 décrit un support d'une unité électronique selon le préambule de la revendication 1.

Usuellement, un dispositif électrique destiné à être intégré dans une machine électrique, tel qu'un convertisseur de tension, comprend des unités électroniques qui nécessitent une isolation efficace à la poussière, aux liquides, aux gaz ou encore à l'humidité. Pour cela, une isolation à l'aide d'un dépôt de matériau isolant peut être réalisée.

Cependant, en général, l'isolation d'un tel dispositif électrique nécessite une quantité importante de matériau isolant afin de garantir une isolation efficace du dispositif électrique. De ce fait, ces dispositifs électriques ont des coûts de production élevés.

La présente invention vise à remédier à ces inconvénients en proposant un support d'une unité électronique permettant de garantir une isolation efficace de l'unité électronique et des éléments de connexion électrique de ladite unité électronique avec une autre unité électronique, tout en réduisant la quantité de matériau isolant nécessaire.

A cet effet, l'invention a pour objet un support d'une unité électronique, notamment une carte électronique, destiné à être intégré dans un boitier pour supporter une première unité électronique et permettre une connexion électrique entre la première unité électronique et une seconde unité électronique située en vis-à-vis, via au moins un élément de connexion électrique, ledit support comprenant :
- une cavité ouverte destinée à recevoir la première unité électronique;
- une colonne creuse dans laquelle le au moins un élément de connexion électrique est destiné à être inséré, la colonne creuse s'étendant depuis la cavité ouverte et étant configurée pour communiquer avec la cavité ouverte à une première extrémité de la colonne creuse ; et
- un canal comprenant une extrémité communiquant avec le fond de la cavité ouverte et une autre extrémité communiquant avec une paroi latérale de la colonne creuse.

Avantageusement, le canal permet de garantir une isolation efficace à l'intérieur de la colonne creuse, et en particulier au niveau des éléments de connexion électrique. En particulier, le canal permet de garantir le remplissage de la colonne creuse, et ainsi d'éviter tout risque de court-circuit au niveau des interconnexions des unités électroniques. Le canal a également pour avantage de permettre une isolation à la fois rapide et peu encombrante.

En outre, la colonne creuse permet de diminuer les coûts de production d'un dispositif électrique comprenant le support d'une unité électronique selon l'invention, grâce à une réduction de la quantité de matériau isolant nécessaire pour isoler efficacement l'unité électronique et les éléments de connexion électrique.

De plus, le support d'unité électronique selon l'invention permet une isolation efficace, sans augmenter la taille du dispositif électrique.

Le support d'une unité électronique selon l'invention peut également comprendre une ou plusieurs des caractéristiques suivantes, considérées individuellement ou selon toutes les combinaisons possibles :
- le canal a une forme générale de rampe ;
- le canal a une forme générale hélicoïdale ;
- le support de la première unité électronique est destiné à recevoir un matériau isolant de sorte que la première unité électronique est noyée dans le matériau isolant ;
- la colonne creuse est destinée à être remplie par ledit matériau isolant, au moins par l'intermédiaire dudit canal, ledit canal formant un élément de remplissage de la colonne creuse ;
- le support d'une unité électronique selon l'invention, dans lequel la première unité électronique est destinée à être connectée électriquement à une pluralité de secondes unités électroniques, le support comprenant :
   - une pluralité de colonnes creuses, chaque colonne creuse s'étendant depuis la cavité ouverte et étant configurée pour communiquer avec la cavité ouverte à une première extrémité de la colonne creuse, chaque colonne creuse étant destinée à recevoir au moins un élément de connexion électrique de chacune de la pluralité de secondes unités électroniques avec la première électronique ; et
   - une pluralité de canaux respectivement de chaque colonne creuse, chaque canal comprenant une extrémité communiquant avec le fond de la cavité ouverte et une autre extrémité communiquant respectivement avec une paroi latérale d'une colonne creuse ;
- le support de la première unité électronique a une forme générale de fer à cheval ;
- le support d'une unité électronique selon l'invention, formant le support d'une unité électronique de contrôle, notamment une carte électronique de contrôle, est destiné à être intégré dans un boitier de machine électrique, pour supporter l'unité électronique de contrôle et permettre une connexion électrique entre l'unité électronique de contrôle et une unité électronique de puissance située en vis-à-vis, via au moins un élément de connexion électrique.

L'invention se rapporte également à un dispositif électrique, notamment destiné à alimenter une machine électrique, comprenant :
- au moins deux unités électroniques situées en vis-à-vis ;
- au moins un élément de connexion électrique destiné à connecter électriquement les au moins deux unités électroniques ; et
- un support de l'une parmi les au moins deux unités électroniques selon l'invention.

Avantageusement, les coûts de production d'un tel dispositif électrique sont réduits, notamment grâce à une réduction de la quantité de matériau isolant et du temps nécessaire pour isoler efficacement l'unité électronique et les éléments de connexion électrique.

Notamment, le dispositif est destiné à être intégré dans une machine électrique.

Notamment, l'une des unités électroniques est une unité électronique de contrôle ; l'autre unité électronique est une unité électronique de puissance.

L'invention concerne également une machine électrique pour véhicule automobile, caractérisée en ce qu'elle comprend au moins un dispositif électrique selon l'invention. Par exemple, la machine électrique est un démarreur, un alterno-démarreur ou une autre machine électrique embarquée dans le véhicule.

D'autres caractéristiques et avantages de la présente invention apparaitront à la lecture de la description et des figures suivantes :
- la figure 1 est une vue éclatée selon un mode de réalisation préféré d'un dispositif électrique selon l'invention,
- la figure 2 représente une vue en coupe d'une carte électronique et d'un support d'une unité électronique selon un mode de réalisation de l'invention, et
- la figure 3 représente une vue en coupe d'un dispositif électrique selon un mode de réalisation de l'invention.

Il est à noter que ces dessins n'ont d'autre but que d'illustrer le texte de la description et ne constituent en aucune sorte une limitation de la portée de l'invention.

Sur les différentes figures, les éléments analogues sont désignés par des références identiques.

Le dispositif électrique selon l'invention est notamment destiné à alimenter une machine électrique, notamment une machine électrique pour un véhicule automobile, telle qu'une machine électrique tournante.

Le dispositif électrique comprend au moins une première unité électronique, par exemple une unité électronique de contrôle, au moins une seconde unité électronique, par exemple une unité électronique de puissance, les deux unités électroniques étant situées en vis-à-vis, au moins un élément de connexion électrique destiné à connecter électriquement les deux unités électroniques, et un support de l'une parmi les deux unités électroniques, par exemple un support de l'unité électronique de contrôle.

Le dispositif électrique est par exemple un convertisseur de tension tel qu'illustré sur les figures. Bien entendu, l'invention n'est nullement limitée à un convertisseur de tension, mais au contraire le dispositif électrique pourrait être tout autre dispositif électrique destiné à contrôler une machine électrique.

De même, la première unité électronique sera illustrée par la suite par une unité électronique de contrôle, telle qu'une carte électronique de contrôle et la seconde unité électronique sera illustrée par une unité électronique de puissance, telle qu'un ou plusieurs modules électroniques de puissance. Bien entendu, les premières et secondes unités électroniques pourraient être respectivement tout autre composant électronique.

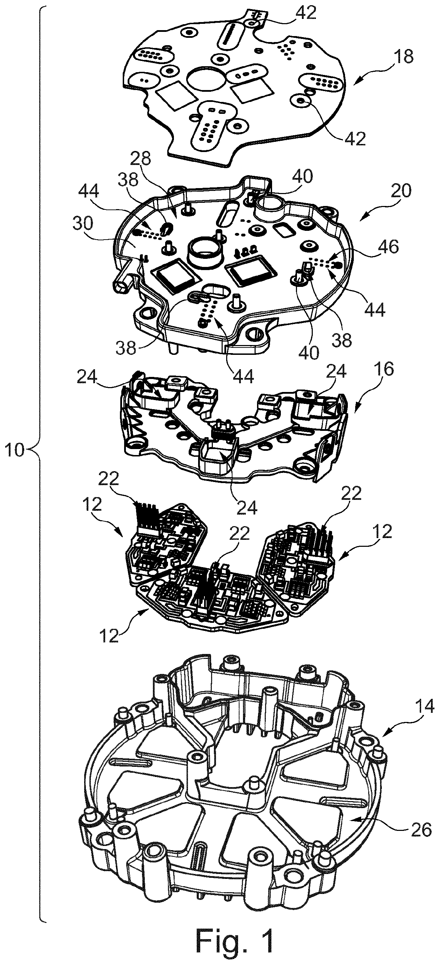

En particulier, la figure 1 représente une vue éclatée d'un convertisseur de tension 10 comprenant des modules électroniques de puissance 12, dans cet exemple au nombre de trois, un support 14 des modules électroniques, un connecteur électrique 16, une carte électronique de contrôle 18, et un support 20 de carte électronique.

Avantageusement, le convertisseur de tension 10 est un convertisseur alternatif-continu. De préférence, le convertisseur de tension 10 est intégré au carter de la machine électrique.

La carte électronique de contrôle 18 est notamment destinée à contrôler les modules électroniques de puissance 12. En particulier, la carte électronique 18 est destinée à être connectée électriquement avec les modules électroniques de puissance 12 via au moins un élément de connexion électrique 22.

Le connecteur électrique 16 est agencé entre les modules électroniques de puissance 12 et le support 20 de la carte électronique. Le connecteur électrique 16 est configuré pour connecter électriquement les modules électroniques 12 à au moins un des éléments électriques (phase cp), de la machine électrique et/ou à au moins un des éléments électriques (B⁺, B⁻) d'une source d'énergie électrique. Les éléments électriques de la machine électrique sont, par exemple, des phases ϕ. Les éléments électriques de la source d'énergie électrique sont par exemple une borne continue positive B⁺, une borne continue négative B⁻ ou la masse. Il y a de préférence un module électronique de puissance 12 par phase ϕ. En outre, comme représenté sur la figure 1, le connecteur électrique 16 comprend des orifices 24 agencés pour autoriser l'accès des éléments de connexion électrique 22 des modules électroniques 12 avec la carte électronique de contrôle 18.

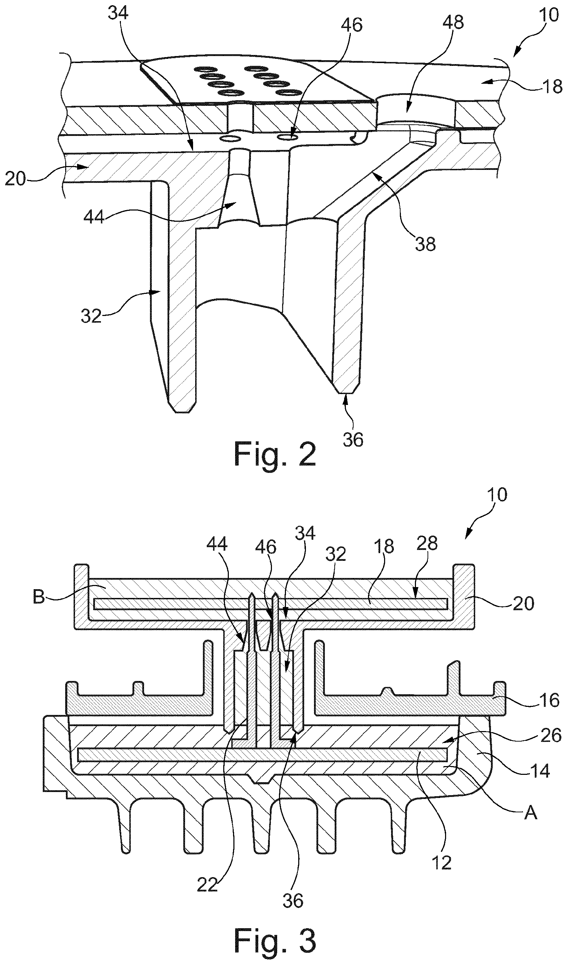

Le support 14 de l'unité électronique de puissance est avantageusement un boitier comprenant au moins une cavité ouverte 26 ayant un fond sur lequel les modules électroniques de puissance 12 sont montés. De façon avantageuse, le boitier permet une conduction thermique et électrique, notamment pour la reprise de la masse et la diffusion thermique. La cavité ouverte 26 est destinée à être remplie d'un matériau isolant A, notamment visible sur la figure 3, de sorte que les modules électroniques de puissance 12 sont noyés dans le matériau isolant A. En particulier, cette configuration permet une isolation efficace des modules électroniques 12. De façon avantageuse, le support 14 de module puissance est un dissipateur de chaleur, aussi nommé dissipateur thermique. Les modules de puissance 12 sont fixés au dissipateur thermique afin de permettre le transfert thermique entre les modules de puissance 12 et un circuit de refroidissement (non représenté), afin de dissiper la chaleur générée par les modules électroniques 12. En outre, la cavité ouverte 26 de réception des modules électroniques peut comprendre des éléments de positionnement (non représentés) destinés à positionner les modules électroniques 12 sur le support 14 dans une position prédéterminée. Ces éléments de positionnement permettent de faciliter et garantir un positionnement correct et rapide des modules électroniques 12 sur le support 14 en vue de leur connexion électrique avec la carte électronique 18.

Le support 20 de la carte électronique de contrôle est agencé entre les modules électroniques de puissance 12 et la carte électronique de contrôle 18. Le support 20 de la carte électronique de contrôle est de préférence en matière isolante, par exemple moulé en matière plastique.

Le support 20 de la carte électronique est destiné à être intégré dans un boitier pour supporter la carte électronique 18. Le support 20 de la carte électronique est destiné à permettre une connexion électrique entre la carte électronique de contrôle 18 et les modules électroniques de puissance 12 situés en vis-à-vis, via au moins un élément de connexion électrique 22.

A cet effet, le support 20 comprend une cavité ouverte destinée à recevoir la carte électronique de contrôle 18, et en particulier, une cavité ouverte 28 ayant un fond 30 sur lequel la carte électronique 18 est destinée à être reçue.

De préférence, le support 20 de la carte électronique a une forme générale de fer à cheval.

En outre, le fond 30 de la cavité ouverte 28 comprend de préférence des éléments de positionnement 40 destinés à positionner la carte électronique 18 sur le support 20 dans une position prédéterminée. Autrement dit, les éléments de positionnement 40 disposés sur le support 20 de la carte électronique sont destinés à coopérer avec des éléments de positionnement complémentaires 42 de la carte électronique 18. Par exemple, sur la figure 1, six éléments de positionnement 40 sont représentés, comprenant chacun un ergot faisant saillie depuis le fond 30 de la cavité ouverte 28, de façon perpendiculaire au fond 30. Les éléments de positionnement 40 peuvent être de forme cylindrique comme représenté sur la figure 1. Les six éléments de positionnement complémentaires 42 de la carte électronique sont des orifices de positionnement présentant de préférence une section de forme et de dimensions complémentaires à la forme et aux dimensions des éléments de positionnement 40. Par exemple, comme illustré sur la figure 1, les éléments de positionnement complémentaires 42 présentent une section circulaire. Ces éléments de positionnement 40 permettent de positionner correctement et rapidement la carte électronique 18 sur le support 20, et ainsi de permettre une connexion électrique efficace de la carte électronique 18 avec les modules électroniques de puissance 12.

Comme illustré sur la figure 2, le support 20 comprend également au moins une colonne creuse 32 dans laquelle le au moins un élément de connexion électrique 22 de la carte électronique 18 avec les modules électroniques 12 est destiné à être inséré.

La colonne creuse 32 s'étend depuis la cavité ouverte 28 et est configurée pour communiquer avec la cavité ouverte 28 à une première extrémité 34 de la colonne creuse 32.

En particulier, sur la figure 1, la carte électronique de contrôle 18 est destinée à être connectée électriquement à une pluralité de modules électroniques de puissance 12, le support 20 de la carte électronique 18 comprenant trois colonnes creuses, chaque colonne creuse étant destinée à recevoir les éléments de connexion électrique 22 de chaque module électronique 12 avec la carte électronique de contrôle 18.

Le support 20 de la carte électronique est destiné à recevoir un matériau isolant B, notamment visible sur la figure 3, de sorte que la carte électronique 18 est noyée dans le matériau isolant B. En particulier, le matériau isolant B est destiné à remplir l'espace intérieur libre de la cavité ouverte 28 autour des composants de la carte électronique 18. La carte électronique de contrôle 18 étant ainsi isolée de manière efficace.

Par exemple, le matériau isolant B peut être une résine, telle qu'une résine époxy, ou un gel isolant, tel qu'un gel de silicone.

Avantageusement, le support 20 de carte électronique de contrôle peut comprendre un canal 38, également appelé élément de remplissage de la colonne creuse 32. Le canal 38 peut avoir une forme générale de rampe, et préférentiellement une forme générale hélicoïdale. Une extrémité du canal 38 communique avec le fond 30 de la cavité ouverte 28 et une autre extrémité du canal 38 communique avec une paroi latérale de la colonne creuse 32. Le canal 38 permet ainsi un accès rapide et peu encombrant à l'intérieur de la colonne creuse 32.

La colonne creuse 32 est destinée à être remplie par le matériau isolant, notamment par l'intermédiaire du canal 38, ledit canal 38 formant un élément de remplissage de la colonne creuse 32.

Le canal 38 assure un remplissage correct de la colonne creuse par le matériau isolant, permettant ainsi de garantir une isolation électrique efficace des éléments de connexion électrique 22 du dispositif électrique 10.

Le support 20 de carte électronique a été décrit comme comprenant un canal 38 associé à une colonne creuse 32. Bien entendu, le support selon l'invention pourrait comprendre plusieurs canaux pour chaque colonne creuse.

Le support 20 peut comprendre une pluralité de canaux 38 tels que décrits précédemment, chaque canal 38 étant associé à une colonne creuse 32. En particulier, sur la figure 1, le support 20 de la carte électronique comprenant trois canaux 38 respectivement de chaque colonne creuse, chaque canal 38 comprenant une extrémité communiquant avec le fond 30 de la cavité ouverte 28 et une autre extrémité communiquant respectivement avec une paroi latérale d'une colonne creuse.

En outre, comme illustré sur la figure 2, la carte électronique de contrôle 18 peut comprendre avantageusement un orifice 48 agencé en vis-à-vis de l'extrémité du canal 38 communiquant avec le fond 30 de la cavité ouverte 28. L'orifice 48 de la carte électronique 18 permet le remplissage de la colonne creuse 32 de matériau isolant B par l'intermédiaire du canal 38.

De préférence, comme illustré sur la figure 3, une seconde extrémité 36 de la colonne creuse 32 est en contact avec le matériau isolant A dans lequel le module électronique 12 est noyé. Cette configuration permet de garantir le remplissage de la colonne creuse 32 de matériau isolant B, et ainsi d'assurer une isolation efficace à la poussière, aux liquides, aux gaz ou encore à l'humidité des éléments de connexion électrique 22. Le matériau isolant permet ainsi de supprimer tout risque de court-circuit possible au niveau de l'interconnexion de la carte électronique 18 avec les modules électroniques de puissance 12.

En particulier, la carte électronique de contrôle 18 et les modules électroniques de puissance 12 peuvent être isolés avec des matériaux isolants A, B identiques ou différents, de préférence un matériau isolant identique, notamment un gel isolant.

L'interface entre le matériau isolant A du module électronique de puissance 12 et le matériau isolant B de la carte électronique de contrôle 18 est notamment située à l'intérieur de la colonne creuse 32, à proximité de la seconde extrémité 36 de la colonne creuse 32.

En outre, l'espace compris entre la carte électronique 18 et le module de puissance 12 et entourant la colonne creuse 32 est dépourvu de matière, notamment de matériau isolant. L'espace libre de matière, notamment de matériau isolant, a, entre autres, pour effet de laisser un espace libre pour la circulation d'air, permettant ainsi un refroidissement par convection. De plus, cette configuration permet de diminuer les coûts de production du dispositif électrique 10, grâce notamment à un gain en matériau isolant.

De plus, le fond 30 de la cavité ouverte 28 comprend avantageusement des éléments de guidage 44 du au moins un élément de connexion électrique 22 agencés à la première extrémité 34 de la colonne creuse 32 et destinés à guider le au moins un élément de connexion électrique 22 vers la carte électronique 18. Par exemple, sur la figure 1, le fond 30 de la cavité ouverte 28 comprend trois groupes d'éléments de guidage 44. Les éléments de guidage 44 comprennent des orifices de guidage 46, avantageusement un orifice de guidage 46 par élément de connexion électrique 22. Les orifices de guidage 46 permettent de recentrer les éléments de connexion électrique 22 en vue de la connexion électrique du module électronique 12 avec la carte électronique 18 et ainsi de connecter correctement le module électronique 12 avec la carte électronique 18. De préférence, afin de permettre un meilleur recentrage des éléments de connexion électrique 22, la section des orifices de guidage 46 en regard du module électronique 12 est plus grande que la section des orifices de guidage 46 en regard de la carte électronique 18. Par exemple, sur la figure 2, les éléments de guidage 44 présentent une section circulaire et comportent une portion tronconique suivie d'une portion cylindrique.

Le dispositif électrique destiné à être intégré dans une machine électrique a été décrit dans le cadre d'un convertisseur de tension destiné à être intégré dans une machine électrique pour véhicule automobile. Bien entendu, l'invention n'est nullement limitée au mode de réalisation décrit et illustré, qui n'a été donné qu'à titre d'exemple. Au contraire, d'autres applications du dispositif électrique conforme à l'invention sont également possibles sans sortir du cadre des revendications.

## Revendications

1. Support (20) d'une unité électronique, notamment une carte électronique, destiné à être intégré dans un boitier pour supporter une première unité électronique (18), ledit support (20) comprenant une cavité ouverte (28) destinée à recevoir la première unité électronique (18) ;
ledit support étant **caractérisé en ce qu'**il est destiné à permettre une connexion électrique entre la première unité électronique (18) et une seconde unité électronique (12) située en vis-à-vis, via au moins un élément de connexion électrique (22) et **en ce qu'**il comprend :
- une colonne creuse (32) dans laquelle le au moins un élément de connexion électrique (22) est destiné à être inséré, la colonne creuse (32) s'étendant depuis la cavité ouverte (28) et étant configurée pour communiquer avec la cavité ouverte (28) à une première extrémité (34) de la colonne creuse (32) ; et
- un canal (38) comprenant une extrémité communiquant avec le fond (30) de la cavité ouverte (28) et une autre extrémité communiquant avec une paroi latérale de la colonne creuse (32).

2. Support d'une unité électronique selon la revendication 1, dans lequel le canal (38) a une forme générale de rampe.

3. Support d'une unité électronique selon la revendication 1 ou 2, dans lequel le canal (38) a une forme générale hélicoïdale.

4. Support d'une unité électronique selon l'une quelconque des revendications précédentes, dans lequel le support (20) de la première unité électronique est destiné à recevoir un matériau isolant (B) de sorte que la première unité électronique (18) est noyée dans le matériau isolant (B).

5. Support d'une unité électronique selon la revendication 4, dans lequel la colonne creuse (32) est destinée à être remplie par ledit matériau isolant (B), au moins par l'intermédiaire dudit canal (38), ledit canal (38) formant un élément de remplissage de la colonne creuse (32).

6. Support d'une unité électronique selon l'une quelconque des revendications précédentes, la première unité électronique (18) étant destinée à être connectée électriquement à une pluralité de secondes unités électroniques (12), le support (20) comprenant :
- une pluralité de colonnes creuses (32), chaque colonne creuse (32) s'étendant depuis la cavité ouverte (28) et étant configurée pour communiquer avec la cavité ouverte (28) à une première extrémité (34) de la colonne creuse (32), chaque colonne creuse (32) étant destinée à recevoir au moins un élément de connexion électrique (22) de chacune de la pluralité de la pluralité de secondes unités électroniques (12) avec la première unité électronique (18) ; et
- une pluralité de canaux (38) respectivement de chaque colonne creuse (32), chaque canal (38) comprenant une extrémité communiquant avec le fond (30) de la cavité ouverte (28) et une autre extrémité communiquant respectivement avec une paroi latérale d'une colonne creuse (32).

7. Support d'une unité électronique selon l'une quelconque des revendications précédentes, dans lequel le support (20) de la première unité électronique a une forme générale de fer à cheval.

8. Support d'une unité électronique selon l'une quelconque des revendications précédentes, formant le support (20) d'une unité électronique de contrôle, notamment une carte électronique de contrôle, est destiné à être intégré dans un boitier de machine électrique, pour supporter l'unité électronique de contrôle (18) et permettre une connexion électrique entre l'unité électronique de contrôle (18) et une unité électronique de puissance (12) située en vis-à-vis, via au moins un élément de connexion électrique (22).

9. Dispositif électrique (10), notamment destiné à alimenter une machine électrique, comprenant :
- au moins deux unités électroniques (12, 18) situées en vis-à-vis ;
- au moins un élément de connexion électrique (22) destiné à connecter électriquement les au moins deux unités électroniques (12, 18) ; et
- un support (20) de l'une parmi les au moins deux unités électroniques (12, 18) selon l'une quelconque des revendications 1 à 8.

10. Machine électrique pour véhicule automobile, **caractérisée en ce qu'**elle comprend au moins un dispositif électrique (10) selon la revendication 9.

## Patentansprüche

1. Halterung (20) einer elektronischen Einheit, insbesondere einer elektronischen Karte, die dazu bestimmt ist, in ein Gehäuse integriert zu werden, um eine erste elektronische Einheit (18) zu halten, wobei die Halterung (20) einen offenen Hohlraum (28) beinhaltet, der dazu bestimmt ist, die erste elektronische Einheit (18) aufzunehmen;
wobei die Halterung **dadurch gekennzeichnet ist, dass** sie dazu bestimmt ist, eine elektrische Verbindung zwischen der ersten elektronischen Einheit (18) und einer zweiten, gegenüberliegenden elektronischen Einheit (12) mittels mindestens eines elektrischen Verbindungselements (22) zu ermöglichen, und dass sie Folgendes beinhaltet:
- eine Hohlsäule (32), in die das mindestens eine elektrische Verbindungselement (22) eingeführt werden soll, wobei sich die Hohlsäule (32) von dem offenen Hohlraum (28) erstreckt und dazu konfiguriert ist, an einem ersten Ende (34) der Hohlsäule (32) mit dem offenen Hohlraum (28) zu kommunizieren; und
- einen Kanal (38), der ein Ende, das mit dem Boden (30) des offenen Hohlraums (28) kommuniziert, und ein anderes Ende, das mit einer Seitenwand der Hohlsäule (32) kommuniziert, beinhaltet.

2. Halterung einer elektronischen Einheit nach Anspruch 1, wobei der Kanal (38) im Allgemeinen rampenförmig ist.

3. Halterung einer elektronischen Einheit nach Anspruch 1 oder 2, wobei der Kanal (38) im Allgemeinen schraubenförmig ist.

4. Halterung einer elektronischen Einheit nach einem der vorhergehenden Ansprüche, wobei die Halterung (20) der ersten elektronischen Einheit dazu bestimmt ist, ein Isoliermaterial (B) aufzunehmen, sodass die erste elektronische Einheit (18) in das Isoliermaterial (B) eingebettet ist.

5. Halterung einer elektronischen Einheit nach Anspruch 4, wobei die Hohlsäule (32) dazu bestimmt ist, mindestens mittels des Kanals (38) mit dem Isoliermaterial (B) ausgefüllt zu werden, wobei der Kanal (38) ein Einfüllelement der Hohlsäule (32) bildet.

6. Halterung einer elektronischen Einheit nach einem der vorhergehenden Ansprüche, wobei die erste elektronische Einheit (18) dazu bestimmt ist, mit einer Vielzahl von zweiten elektronischen Einheiten (12) elektrisch verbunden zu werden, wobei die Halterung (20) Folgendes beinhaltet:
- eine Vielzahl von Hohlsäulen (32), wobei sich jede Hohlsäule (32) von dem offenen Hohlraum (28) erstreckt und dazu konfiguriert ist, an einem ersten Ende (34) der Hohlsäule (32) mit dem offenen Hohlraum (28) zu kommunizieren, wobei jede Hohlsäule (32) dazu bestimmt ist, mindestens ein elektrisches Verbindungselement (22) jeder der Vielzahl von zweiten elektronischen Einheiten (12) mit der ersten elektronischen Einheit (18) aufzunehmen; und
- eine Vielzahl von Kanälen (38) von jeweils jeder Hohlsäule (32), wobei jeder Kanal (38) ein Ende, das mit dem Boden (30) des offenen Hohlraums (28) kommuniziert, und ein anderes Ende, das jeweils mit einer Seitenwand einer Hohlsäule (32) kommuniziert, beinhaltet.

7. Halterung einer elektronischen Einheit nach einem der vorhergehenden Ansprüche, wobei die Halterung (20) der ersten elektronischen Einheit im Allgemeinen hufeisenförmig ist.

8. Halterung einer elektronischen Einheit nach einem der vorhergehenden Ansprüche, die die Halterung (20) einer elektronischen Steuereinheit, insbesondere einer elektronischen Steuerkarte, bildet, die dazu bestimmt ist, in ein Gehäuse einer elektrischen Maschine integriert zu werden, um die elektronische Steuereinheit (18) zu halten und mittels mindestens eines elektrischen Verbindungselements (22) eine elektrische Verbindung zwischen der elektronischen Steuereinheit (18) und einer gegenüberliegenden elektronischen Leistungseinheit (12) zu ermöglichen.

9. Elektrische Vorrichtung (10), die insbesondere dazu bestimmt ist, eine elektrische Maschine mit Strom zu versorgen, beinhaltend:
- mindestens zwei sich gegenüberliegende elektronische Einheiten (12, 18);
- mindestens ein elektrisches Verbindungselement (22), das dazu bestimmt ist, die mindestens zwei elektronischen Einheiten (12, 18) elektrisch zu verbinden; und
- eine Halterung (20) der einen von den mindestens zwei elektronischen Einheiten (12, 18) nach einem der Ansprüche 1 bis 8.

10. Elektrische Maschine für ein Kraftfahrzeug, **dadurch gekennzeichnet, dass** sie mindestens eine elektrische Vorrichtung (10) nach Anspruch 9 beinhaltet.

## Claims

1. Holder (20) for an electronic unit, especially a circuit board, which holder is intended to be integrated into a casing in order to hold a first electronic unit (18), said holder (20) comprising an open cavity (28) intended to receive the first electronic unit (18); said holder being **characterized in that** it is intended to allow an electrical connection between the first electronic unit (18) and a second electronic unit (12) located facing, via at least one electrical connection element (22), and **in that** it comprises:
- a hollow column (32) into which the at least one electrical connection element (22) is intended to be inserted, the hollow column (32) extending from the open cavity (28) and being configured to communicate with the open cavity (28) at a first end (34) of the hollow column (32); and
- a channel (38) comprising an end that communicates with the bottom (30) of the open cavity (28) and another end that communicates with a sidewall of the hollow column (32).

2. Holder of an electronic unit according to Claim 1, wherein the channel (38) has a ramp-like general shape.

3. Holder of an electronic unit according to Claim 1 or 2, wherein the channel (38) has a helicoidal general shape.

4. Holder of an electronic unit according to any one of the preceding claims, wherein the holder (20) of the first electronic unit is intended to receive an insulating material (B) so that the first electronic unit (18) is embedded in the insulating material (B).

5. Holder of an electronic unit according to Claim 4, wherein the hollow column (32) is intended to be filled with said insulating material (B), at least by way of said channel (38), said channel (38) forming an element for filling the hollow column (32).

6. Holder of an electronic unit according to any one of the preceding claims, the first electronic unit (18) being intended to be electrically connected to a plurality of second electronic units (12), the holder (20) comprising:
- a plurality of hollow columns (32), each hollow column (32) extending from the open cavity (28) and being configured to communicate with the open cavity (28) at a first end (34) of the hollow column (32), each hollow column (32) being intended to receive at least one electrical connection element (22) of each of the plurality of second electronic units (12) with the first electronic unit (18); and
- a plurality of channels (38) respectively of each hollow column (32), each channel (38) comprising an end that communicates with the bottom (30) of the open cavity (28) and another end that communicates respectively with a sidewall of a hollow column (32) .

7. Holder of an electronic unit according to any one of the preceding claims, wherein the holder (20) of the first electronic unit has a horseshoe general shape.

8. Holder of an electronic unit according to any one of the preceding claims, forming the holder (20) of an electronic control unit, especially a control circuit board, which holder is intended to be integrated into a casing of an electric machine, in order to hold the electronic control unit (18) and to allow an electrical connection between the electronic control unit (18) and an electronic power unit (12) located facing, via at least one electrical connection element (22).

9. Electrical device (10), especially intended to supply power to an electric machine, comprising:
- at least two electronic units (12, 18) located facing;
- at least one electrical connection element (22) intended to electrically connect the at least two electronic units (12, 18); and
- a holder (20) of one among the at least two electronic units (12, 18) according to any one of Claims 1 to 8.

10. Electric machine for motor vehicle, **characterized in that** it comprises at least one electrical device (10) according to Claim 9.
